# EUROPEAN PATENT APPLICATION

(11) **EP 2 533 349 A1**
(43) Date of publication of application: **12.12.2012**
(21) Application number: 10845131.1
(22) Date of filing: 04.02.2010
(51) Int. Cl.: H01M 10/48, G01R 31/36

(54) **ELECTRICITY SUPPLY SYSTEM FOR VEHICLES**

(71) Applicant: Ecomotive Inova Consultores, S.L., 08007 Barcelona (ES)
(72) Inventor: VENTURA FORÉS, Jorge, E-08017 Barcelona (ES); TOBÍAS LÓPEZ, José Angel, E-08017 Barcelona (ES)
(74) Representative: Ungria Lopez, Javier
(86) International application number: PCT/ES2010/070060
(87) International publication number: WO 2011/095650

(57) **Abstract**

The invention relates to an electricity supply system for vehicles, which has a connector device that includes an electronic board provided with a data microprocessor; a plurality of connector plugs arranged in parallel and connected to one another to couple to a plurality of removable rechargeable batteries; a connection to the electronic board provided with a continuous current BUS to couple to the electrical system of the engine of the corresponding vehicle; and a discriminator such that the electronic board is able to identify the electrical supply from any of the plurality of removable batteries, such that when the rechargeable batteries are discharged or low they can be recharged from an external electricity source such as the general electricity grid.

## Description

### FIELD OF THE INVENTION

The object of the present patent application is to register an electrical supply system for vehicles, which incorporates significant innovations and benefits.

More particularly, the invention proposes the development of an electricity supply system for vehicles of either two or more wheels, which allows the use of rechargeable batteries that can be removed to supply power to electric engines.

### BACKGROUND OF THE INVENTION

It has been widely well known for years, the search for appropriate solutions to replace conventional combustion engines, taking into account the yearly increment of the amount of vehicles in urban areas. To this end, new applications of electric engines in vehicles having a smaller size are being devised, either in a hybrid form or fully electrical, which allow reducing the CO₂ emissions.

However, the systems currently used require constructing infrastructures especially devised to recharge the batteries of the vehicles given that the batteries and electric systems do not allow being removed from the vehicle in a practical and quick way, essentially due to size and weight reasons, and the user is forced to carry out the recharge sometimes from a distant point. In addition, the construction of such infrastructures has relatively high manufacturing and maintenance costs, so there is the possibility of finding more economical solutions that allow their viability.

### DESCRIPTION OF THE INVENTION

The present invention has been developed in order to provide a system able to solve the aforementioned disadvantages, contributing also with other additional advantages that will become apparent from the following description.

It is an object of the present invention to provide a new electricity supply system for vehicles, which presents a connector device comprising: an electronic board provided with a data microprocessor, a plurality of connector plugs arranged in parallel to couple to a plurality of removable rechargeable batteries, a connection to the electronic board provided with a continuous current BUS to couple to the electrical system of the engine of the corresponding vehicle, and a discriminator such that the electronic board is able to discriminate the electrical supply coming from any of the plurality of removable batteries. This way, when the rechargeable batteries are discharged or low they can be recharged from an external electricity source such as the general electricity grid.

Thanks to the system defined above, the user of the vehicle can extract the batteries and recharge them from any electricity supply point, for instance, a household connection located at any house or building, so the user is not forced to leave the vehicle at a specific point or even at a far away point.

Another aspect, nor the less beneficial, is that it avoids the construction of infrastructures specially designed for the recharge of electric vehicles at public thoroughfares.

Another advantage to bear in mind is the fact that batteries can subsequently be recharged using conventional chargers with universal plugs like those used to recharge mobile phones.

According to another aspect of the invention, the electricity supply system comprises temperature sensors associated with each of the batteries as well as voltage sensors associated with each of the rechargeable batteries that transmit the captured data to the electronic board, by means of a data interface, so it allows optimizing the operation of the connector device.

In addition, the BUS includes sectionalizing switches that allow the opening and closing power circuits according to the state of charge of the rechargeable batteries.

Further features and advantages of the system object of the present invention will become apparent from the description of a preferred embodiment, but not exclusive, that is illustrated by way of no limitative example in the attached drawings, wherein:

### BRIEF DESCRIPTION OF THE DRAWINGS

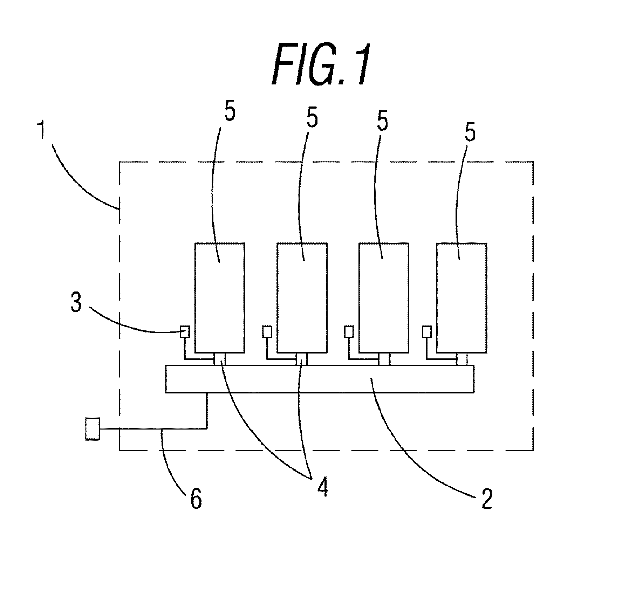

Figure 1. - Is a schematic view of a connector device that makes part of the system according to the present invention.

### DESCRIPTION OF A PREFERRED EMBODIMENT

As it can be seen in the attached figure, an embodiment of the electricity supply system for vehicles, such as, for instance, motorbikes and automobile vehicles (no represented), presents a connector device 1 (represented in the figure with a dashed line) comprising an electronic board 2 provided with a latest data microprocessor available with a management program that allows to introduce voltage, temperature and current values by means of a number of sensors 3 in a series of specific algorithms employed in the electrochemical technology, four connector plugs 4 of a known type (being each one of them constituted by a negative pin and a positive pin) arranged in parallel to be coupled to four removable rechargeable batteries 5 of reduced dimensions and a connection 6 to the electronic board 2 provided with a continuous current BUS to be coupled to the electrical system of the engine of the corresponding vehicle.

In addition, the microprocessor is provided with a discriminator such that the electronic board 2 is able to discriminate the electricity supply from any of the plurality of removable batteries 5.

The connector device 1 can be arranged inside a base body or casing made of any proper material in which are located the aforementioned elements for protecting them against dirt and shocks. The rechargeable batteries 5 have dimensions such that the user may carry them easily and with a minimum effort, and a capacity such that the sum of all of them together has a power equivalent to a conventional electric battery. Thus in the case of electric motorbikes the batteries employed (supplied by the commercial company Saft Baterias) are based on the technology lithium-ion having a nominal voltage of 72 V and a stored energy of 0.5 Kwh. One of the rechargeable batteries 5 can be taken as main battery and the remaining as secondary, having the possibility that the main battery receives recharge power through the regenerative braking process of the according vehicle when the driving conditions allow so, each battery having a minimum autonomy for the vehicle of approximately 20 Km in normal driving conditions.

It is also provided with a communication port linked to the vehicle manager in which is mounted the connector device, that allows informing to the driver about the state of the batteries.

The details, shapes, dimensions and remaining accessory elements, as well as the materials used in the manufacturing process of the system of the invention may be conveniently replaced by other ones technically equivalent as long as they do not depart from the essentiality of the invention or the scope thereof defined by the claims included below.

## Claims

1. Electricity supply system for vehicles, **characterized by** the fact that it presents a connector device (1), which comprises:
an electronic board (2) provided with a data microprocessor;,
a plurality of connector plugs (4) arranged in parallel and interconnected one to another to couple to a plurality of removable rechargeable batteries (5);
a connection linked to the electronic board provided with a continuous current BUS to couple to the electrical system of the engine of the corresponding vehicle; and
a discriminator such that the electronic board is able to discriminate the electrical supply from any of the plurality of removable batteries (5),
in such a way that when the rechargeable batteries (5) are discharged or low they can be recharged from an external electricity source such as the general electricity grid.

2. Electricity supply system for vehicles according to claim 1, **characterized by** the fact that it comprises temperature sensors associated to each one of the rechargeable batteries (5), which transmit to an electronic board (2) the captured data by means of a data interface.

3. Electricity supply system for vehicles according to claim 1, **characterized by** the fact that it comprises voltage sensors associated to each one of the rechargeable batteries (5) that transmit to the electronic board (2) the captured data by means of a data interface.

4. Electricity supply system for vehicles according to claim 1, **characterized by** the fact that the BUS includes isolator switches that allow the opening and closing of power circuits according to the state of charge of the rechargeable batteries (5).
